# EUROPÄISCHE PATENTSCHRIFT

(11) **EP 2 269 757 B1**
(45) Veröffentlichungstag und Bekanntmachung des Hinweises auf die Patenterteilung: **16.01.2013**
(21) Anmeldenummer: 09008536.6
(22) Anmeldetag: 30.06.2009
(51) Int. Cl.: B23K 1/00, B23K 1/005, B23K 3/06, B23K 3/08, H01L 31/05, H01L 31/18

(54) **Vorrichtung zum Löten eines Verbinders mit einer Solarzelle mit einer Reinigungseinrichtung**
Apparatus to solder a connector with a solar cell with a cleaning unit
Appareil de brasage d'un connecteur et d'une cellule solaire avec une unité de nettoyage

(43) Veröffentlichungstag der Anmeldung: 05.01.2011
(73) Patentinhaber: Mikron Berlin GmbH, 12623 Berlin (DE)
(72) Erfinder: Nowak, Andreas, Dipl.-Ing., 16341 Panketal (DE)
(74) Vertreter: Hannig, Wolf-Dieter

(56) Entgegenhaltungen:
- EP-A- 1 291 929
- DE-A1-102006 022 818
- JP-A- 10 308 579
- US-A1- 2001 045 444

## Beschreibung

Die Erfindung betrifft eine Vorrichtung zum Löten eines Verbinders aus verzinntem Lötband mit einer Solarzelle zur Herstellung von Solarzellenstrings gemäß dem Oberbegriff des Anspruchs 1 (siehe, z.B., EP 1 291 929 A1).

### Stand der Technik

Aus der DE 103 35 438 B4 ist ein Verfahren zum Löten unter Vorspannung bekannt, bei dem die Erwärmung mit einem stromdurchflossenen Induktor erfolgt und eine Kraft auf die Lötstelle mit einer Andruckplatte aus elektrisch nichtleitfähigem Material ausgeübt wird.
Mit dem separaten Aufbringen einer Andruckplatte auf die Fügepartner aus Verbinder und Solarzelle mag zwar die Ausübung einer mechanischen Druckkraft beim Löten möglich sein, jedoch führt ein solches Fremdteil bei einem automatisierten Herstellungsprozess zu Komplikationen, insbesondere zu einem erheblichen Mehraufwand an Baugruppen und Bauteilen in der Lötstation. Die indirekte Druckausübung mittels einer Druckplatte begrenzt die Taktzahl, d.h. den Durchsatz bei der Fertigung.
Außerdem hat die Druckplatte gegenüber einer punktuellen Lötstelle eine wesentlich größere Flächenausdehnung und führt daher bei ihrer Verspannung zu einer nicht mehr zu vernachlässigenden und unkontrollierten Krafteinwirklung auf einen größeren Flächenbereich der empfindlichen Solarzelle. Von Nachteil ist weiterhin, dass die Löttemperatur in der Nähe der Lötstelle nicht ermittelt werden kann. so dass es sehr schwierig wird, die Temperaturbelastung zu ermitteln und reproduzierbar einzustellen.

Weiterhin ist aus der DE 10 2006 022 818 A1 eine Verbindungseinrichtung zur Verschaltung von Solarzellen für Solarmodule mittels Verbindungselementen, insbesondere lötbaren Leitungsverbindern, bekannt, die aus einem gesteuerten Zuführ- und Fügekopf und einer Halteinrichtung besteht. Der Zuführ- und Fügekopf besitzt in Richtung der zu kontaktierenden Solarzelle hin mindestens eine Vertiefung, deren Form mit der Form des Leitungsverbinders korrespondiert, so dass ein Anpressen des Verbinders auf die Solarzelle erfolgt.
Von Nachteil bei dieser bekannten Lösung ist, dass bei der Zustellung des Fügekopfes auf die Solarzelle die Vertiefung im Fügekopf exakt der Lage des Lotverbinders auf der Solarzelle entsprechen muss. Dies limitiert einerseits die Taktzeit und führt andererseits bei Lageabweichungen zu variierenden Anpressdrücken, was insbesondere die Qualität der Verbindung beeinträchtigt.

Ferner ist aus der EP 1 291 929 A1 ein Verfahren und eine Vorrichtung zur Herstellung eines Solarzellenbandes aus mehreren aneinandergereihten, mit Lötbändern elektrisch und mechanisch verbundenen Solarzellen bekannt, bei dem mehrere Solarzellen aneinandergereiht und an die Solarzellen diese verbindende, mit Lot überzogene Lötbänder gelötet werden.

Es kommen kammartige Lötstempel zum Einsatz, die als Pressorgan wirken.

Des Weiteren beschreibt die US 2001/045444A1 ein Lötverfahren zum Löten von gedruckten Schaltungen, bei dem die Lötkolben horizontal quer zur Laufrichtung zum Reinigen der Lötkolben mittels Pressluft verschoben werden.

### Aufgabenstellung

Bei diesem Stand der Technik liegt der Erfindung die Aufgabe zugrunde, eine Vorrichtung zum Hochleistungslöten eines Verbinders aus verzinntem Lötband mit einer Solarzelle zur Herstellung von Solarzellenstrings bereitzustellen, die ein punktuelles Hochleistungslöten mit einer definierten Druckkraft und reproduzierbarer Temperaturbelastung unter gleichzeitiger Verringerung des maschinentechnischen Aufwandes, der Erhöhung des Durchsatzes und der Qualität sowie Beibehaltung einer hohen Flexibilität gewährleistet.

Diese Aufgabe wird durch eine Vorrichtung der eingangs genannten Gattung mit den Merkmalen des Anspruchs 1 gelöst.

Vorteilhafte Ausgestaltungen der erfindungsgemäßen Vorrichtung sind den Unteransprüchen entnehmbar.

Die erfindungsgemäße Lösung geht von der Erkenntnis aus, die mechanische Druckkraft beim Anpressen des Verbinders auf die Solarzelle direkt durch die Lötelemente, d.h. durch die Lötspitzen des Lötkopfes, in definierter Größe aufzubringen und gleichzeitig die Temperatur in der Nähe der Lötstelle reproduzierbar einzustellen.

Dies wird dadurch erreicht, dass die Lötstation umfasst
a) mindestens eine Zustelleinheit für ein separates vertikales Absenken des Lötkopfgehäuses in eine unterhalb ihrer horizontalen Verfahrlage gelegenen Arbeitsposition auf der lagefixierten Anordnung von Verbinder und Solarzelle auf dem Transportband oder ein vertikales Anheben aus der Arbeitsposition in die Verfahrlage,
b) einen Pneumatikzylinder zum Erzeugen einer schnellen Absenkbewegung des Lötkopfgehäuses, der in einer Schräglage innerhalb der Zustelleinheit) um sein der Zylinderstange abgewandtes Ende schwenkbar angeordnet ist, wobei die Zylinderstange des Pneumatikzylinders mit einem Arm eines Winkelhebels zur Verlangsamung am Ende der Zustellbewegung schwenkbar verbunden ist, dessen anderer Arm schwenkbar an einem Träger für das Lötkopfgehäuse angelenkt ist und der Winkelhebel um eine zu den Armen etwa symmetrisch angeordnete Achse drehbar ist;
c) mindestens einen, insbesondere mehrere vom Lötkopfgehäuse haltenen, Lötspitzen tragende/n Lötstift/e zum Aufbringen einer definierten Druckkraft beim Aufsetzen der oder des Lötstifte(s) auf den Verbinder (10) und der Solarzelle, wobei jeder Lötstift mit einem vertikalen Ausgleichsystem versehen ist, das die Druckkraft beim Löten von Verbinder und Solarzelle durch eine definierte Federkraft aufbringt;
d ein den Lötstiften zugeordneten, horizontal verfahrbaren und vertikal in die bzw. von der Arbeitsposition absenk- oder anhebbaren Niederhalter mit Niederhalteleistendurch eine Zustelleinheit zum Niederhalten der Verbinder auf der Solarzelle beim Löten in der Arbeitsposition oder zum Freigeben der Solarzelle nach dem Löten und Abkühlen zu ihrem taktweisen Weitertransport mit dem Transportband;
e eine jeder Löteinheit quer zur Laufrichtung des Transportbandes zugeordnete Reinigungseinrichtung zum periodischen Reinigen der mit Lötspitzen versehenen Lötstifte.

In einen vorteilhaften Ausgestaltung der erfindundsgemäβen Vorrrichtung ist ein Linearantrieb zum horizontalen Verfahren des Schlittens entlang einer am Grundgestell befestigten Schiene quer zur Laufrichtung des Transportbandes vorgesehen, der von einem Antrieb, vorzugsweise Elektromotor, angetrieben ist. Dadurch ist es möglich, dass der Schlitten mit der Löteinheit eine Verfahrbewegung quer zur Laufrichtung des Transportbandes ausführen kann.

In einer weiteren bevorzugten Ausgestaltung der erfindungsgemäßen Vorrichtung ist vorgesehen, dass das Lötkopfgehäuse mindestens eine vertikal angeordnete Führungsbuchse aufweist, in der der Lötstift linear geführt angeordnet ist.
Jeder Lötstift ist in einer vorteilhafterweise Ausgestaltung der erfindungsgemäßen Vorrichtung mit einem Ausgleichsystem versehen, das eine in der Führungsbuchse eingesetzte Druckfeder umfasst, die sicherstellt, dass die Lötspitze bei ihrem Aufsetzen auf den Verbinder eine definierte Druckkraft beim Löten ausübt. Die Höhe der Druckkraft lässt sich durch die Wahl der Druckfeder ist exakter Weise festlegen.
Dieses Ausgleichsystem kann aber in einer weiteren bevorzugten Ausgestaltung auch aus mindestens zwei vertikal übereinander am Lötkopfgehäuse befestigten Blattfedern gebildet sein, die sowohl die Zustellkraft auf den Verbinder und die Führung des Heftstiftes übernehmen.

Nach einer vorteilhaften Ausführungsform der erfindungsgemäßen Vorrichtung weist die Zustelleinheit zum Erzeugen einer schnellen Absenkbewegung des Lötkopfgehäuses einen Pneumatikzylinder auf, der in einer Schräglage innerhalb der Zustelleinheit um sein der Zylinderstange abgewandtes Ende schwenkbar angeordnet ist, wobei die Zylinderstange des Pneumatikzylinders mit einem Arm eines Winkelhebels zur Verlangsamung am Ende der Zustellbewegung schwenkbar verbunden ist, dessen anderer Arm schwenkbar an einem Träger für das Lötkopfgehäuse angelenkt ist und der Winkelhebel um eine zu den Armen etwa symmetrisch angeordnete Achse drehbar ist. Dies ermöglicht einen annähernd sinuiden Bewegungsablauf, d.h. die Zustellbewegung des Lötkopfes verläuft am Anfang der Bewegung schnell in Richtung des zu lötenden Verbinders und am Ende der Bewegung gebremst, so dass der Lötstift mit seiner Lötspitze schonend auf den Verbinder und damit auf die Solarzelle aufsetzt. Bevorzugt ist dabei vorgesehen, dass der Träger für das Lötkopfgehäuse in zueinander parallel angeordneten Führungen vertikal verschiebbar ist, wodurch alle zum Lötkopf gehörenden Lötspitzen gleichmäßig abgesenkt werden können und gleichzeitig auf dem Verbinder aufsetzen.
Natürlich gehört es auch zu der Erfindung, wenn anstelle eines pneumatischen Antriebs ein elektrischer Antrieb für die Zustellbewegung eingesetzt wird.

Eine weitere bevorzugte Ausführungsform der erfindungsgemäßen Vorrichtung sieht vor, dass die Anzahl der in der Löteinheit einzeln aufgehängten Lötköpfe der Anzahl der mit der Solarzelle zu verlötenden Verbinder entspricht. Die erfindungsgemäße Vorrichtung ist somit auf Solarzellen mit unterschiedlichen Größen und verschiedener Anzahl von Verbindern problemlos umrüstbar.

Von besonderem Vorteil ist weiterhin, dass die Lötspitze als Verschleißteil ausgebildet ist, so dass ein einfacher Austausch der Lötspitzen vorgenommen werden kann, sobald die Lötspitzen abgenutzt sind. Dies erhöht die Wartungsfreundlichkeit erheblich, weil die Lötstifte in ihren Führungsbuchsen verbleiben können und der Austauschvorgang einfach und wenig zeitintensiv ist. Die Lötspitzen sind außerdem separat wechselbar, so dass immer nur die tatsächlich verschlissene Lötspitze ausgetauscht werden kann.

Nach einer weiteren Gestaltungsvariante der erfindungsgemäßen Vorrichtung ist in den Lötstift eine Heizpatrone mit einem Temperatursensor eingesetzt, der es gestattet, die Temperatur beim Löten genau zu kontrollieren und einzuhalten.

In einer weiteren bevorzugten Ausgestaltungsform der erfindungsgemäßen Vorrichtung weist der Niederhalter mindestens eine separate vertikal verfahrbare Zustelleinheit zum Absenken und Heben der Niederhalterleisten auf, die jeweils an einem separaten Schlitten befestigt sind. Der Niederhalter ist mit dem separaten Schlitten um maximal einen Zellentakt horizontal verfahrbar, so dass sich die Niederhalterleisten synchron mit dem Transportband bewegen können.

In einer besonders bevorzugten Ausgestaltungsvariante der erfindungsgemäßen Vorrichtung ist das Lötkopfgehäuse mittels der Zustelleinheit für das Lötkopfgehäuse und einer weiteren Zustelleinheit für die Löteinheit aus der Arbeitsposition in die horizontale Verfahrlage bringbar, in der die Löteinheit mit dem Schlitten über die Reinigungseinrichtung verfahrbar und durch eine Zustelleinheit die Lötstifte und Lötspitzen in eine Reinigungsposition bringbar sind.

Nach einer weiteren vorteilhaften Ausführungsform der erfindungsgemäßen Vorrichtung weist die Reinigungseinrichtung zwei zueinander gegenläufige, mit einer zur Aufnahme von Reinigungsflüssigkeit geeignete Schwammbeschichtung versehene Walzen auf, die mit einem Elektromotor zum Antrieb verbunden sind.

Weitere Vorteile und Einzelheiten der Erfindung ergeben sich aus der nachfolgenden Beschreibung unter Bezugnahme auf die beigefügten Zeichnungen.

### Ausführungsbeispiel

Die Erfindung soll nachstehend an einem Ausführungsbeispiel näher erläutert werden.
Es zeigt

Fig. 1 eine perspektivische Darstellung der erfindungsgemäßen Vorrichtung,

Fig. 2 eine perspektivische Darstellung der Löteinheit mit drei eingehängten Lötköpfen,

Fig. 3 den Aufbau des Lötkopfes aus Zustelleinheit, Lötkopfgehäuse und Lötstifte in perspektivischer Darstellung,

Fig. 4 eine perspektivische Darstellung der Zustelleinheit des Lötkopfes,

Fig. 5 einen Schnitt durch das Lötkopfgehäuse mit mehreren in das Gehäuse eingesetzten Lötstiften in perspektivische Ansicht,

Fig. 6 eine schematische Darstellung einer weiteren Variante des Ausgleichssystems für den Lötstift,

Fig. 7 eine perspektivische Darstellung des Niederhalters und

Fig. 8 eine Ansicht der Reinigungseinrichtung.

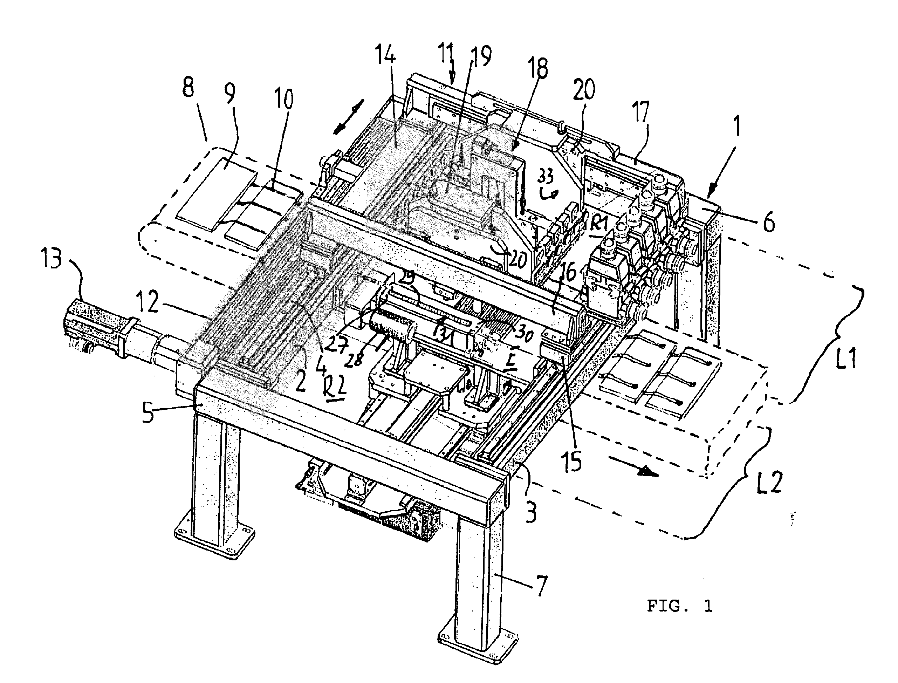

Die Fig. 1 zeigt ein Grundgestell 1, dass als Träger für alle Baugruppen und Bauteile der erfindungsgemäßen Vorrichtung dient. Das Grundgestell 1 ist als Rahmengestell ausgeführt, auf dessen Längsstreben 2 und 3 je eine Laufschiene 4 montiert ist. Die Längsstreben 2 und 3 sind durch Querstreben 5 und 6 miteinander verbunden. Quer- und Längsstreben stützen sich auf Vertikalstützen 7 ab. Das Transportband 8 für die getaktete Zuführung von Solarselle 9 und Verbinder 10 in lagefixierter Anordnung ist gestrichelt in der Fig. 1 angedeutet und verläuft quer zu den Längsstreben 2 bzw. 3 des Grundgestells 1.

Auf den Laufschienen 4 der Längsstrebe 2 und 3 ist ein Schlitten 11 horizontal verfahrbar geführt, der von einem entlang der Längsstrebe 2 befestigten Linearantrieb 12 durch einen Elektromotor 13 aus einer ersten horizontalen Lage L1 in eine zweite horizontale Lage L2 und zurück verfahrbar ist.
Der Schlitten 11 setzt sich aus den Längsträgern 14 bzw. 15 und Querträgern 16 bzw. 17 zusammen, die die Längsträger 14 bzw. 15 zu einem modularen Korpus miteinander verbinden. Der Schlitten 11 hat eine solche Abmessung, dass das Grundgestell in annähernd zwei gleich große Aufnahmebereiche R1 und R2 aufgeteilt ist. Mit anderen Worten, die Abmessung der Grundfläche des Grundgestells 1 ist etwa annähernd doppelt so groß wie die Grundfläche des Schlittens 11.

Der Schlitten 11 trägt eine Löteinheit 18, die jeweils an den beiden Querträgern 16 bzw. 17 über je eine Zustelleinheit 19 und Befestigungsplatte 20 befestigt ist. Die Zustelleinheit 19 ermöglicht ein vertikales Absenken der Löteinheit 18 in den Aufnahmebereich R1 des Grundgestells 1 in Bezug auf die lagefixierte Anordnung aus Verbinder 10 und Solarzelle 9 auf dem Transportband 8 oder ein Anheben der Löteinheit in ihre horizontale Verfahrposition.
Nach Fig. 1 ist in die Löteinheit 18 ein Lötkopf 22 mit in einer Reihe nebeneinander angeordneten Lötstiften 24 eingehängt.
Ebenso kann die Löteinheit 18 mehrere hintereinander quer zur Laufrichtung LR angeordnete Lötköpfe 22 aufnehmen, wobei die Lötstifte 24 in Längsrichtung LR des Transportbandes 8 angeordnet sind und die Anzahl der Lötköpfe 22 der Anzahl der Verbinder 10 für die Solarzelle 9 entspricht.

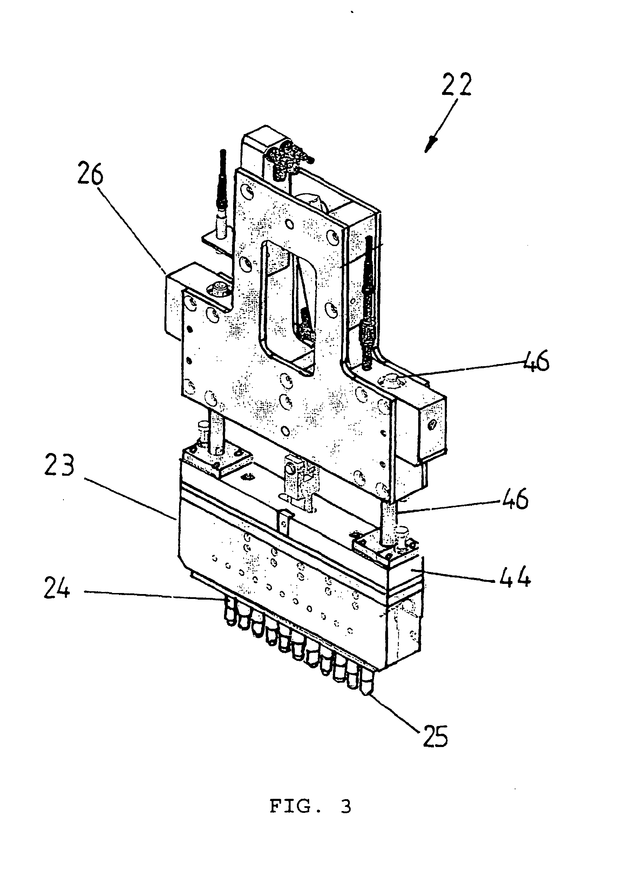

Der Lötkopf 22 besteht aus einem Lötkopfgehäuse 23 (siehe Fig. 3), den darin aufgenommenen Lötstiften 24 mit aufgesetzten Lötspitzen 25 und einer Zustelleinheit 26, auf die in den Abschnitten [0035] und [0036] näher eingegangen wird.

Im Aufnahmebereich R2 des Grundgestells 1 ist eine Reinigungseinrichtung 27 an den Längsstreben 2 und 3 befestigt. Die Reinigungseinrichtung 27 liegt etwa in der von den Längstreben 2 bzw. 3 und den Querstreben 5 und 6 des Grundgestells 1 aufgespannten Ebene E, die annähernd unterhalb der horizontalen Verfahrlage des Schlittens 11 verläuft.

Die Reinigungseinrichtung 27 besteht aus zwei gegenläufig durch einen Elektromotor 28 angetriebene Walzen 29, die mit einer Schwammbeschichtung zur Aufnahme von Reinigungsflüssigkeit für die Lötstifte 24 versehen sind. Die Walzen 29 sind in einem Gehäuse 30 untergebracht, das mit Reinigungsflüssigkeit gefüllt ist. Das Gehäuse 30 weist auf seiner der Ebene E zugewandten Seite eine Arbeitsöffnung 31 auf.

Zum Reinigen der später noch zu beschreibenden Lötstifte 24 verfährt der Schlitten 11, nachdem eine Zustelleinheit 19 die Lötköpfe 22 angehoben hat, aus seiner horizontalen Verfahrlage LI auf den Laufschienen 4 in die horizontale Lage L2 oberhalb der Reinigungseinrichtung 27. Dabei wird der Lötkopf 22 mit seinen Lötstiften 24 so zur Arbeitsöffnung 31 positioniert, dass die Lötstifte 24 mit der Arbeitsöffnung 31 fluchten. Durch die Zustelleinheit 26 wird das Lötkopfgehäuse 23 soweit vertikal abgesenkt, dass die Lötstifte 24 mit ihren Lötspitzen 25 in die Arbeitsöffnung 31 eintauchen können und von der mit Reinigungsflüssigkeit getränkten Schwammbeschichtung der rotierenden Walzen 29 erfasst und gereinigt werden. Nach Abschluss des Reinigungsvorgangs hebt die Zustelleinheit 26 das Lötkopfgehäuse 23 wieder bis in die horizontale Verfahrlage an und der Schlitten 11 verfährt zurück in die horizontale Verfahrlage L1. Die Löteinheit 18 steht dann wieder zum vertikalen Absenken der Lötköpfe 22 durch die jeweilige Zustelleinheit 19 bzw. 26 in die Arbeitsposition bereit.
Der Zyklus der Reinigung wird durch eine nicht weiter dargestellte Steuerung veranlasst.
Es gehört natürlich auch zu der Erfindung, wenn die Absenk- bzw. Hubbewegung von Löteinheit 18 und Lötkopfgehäuse nur mit einer einzigen Zustelleinheit bewerkstelligt wird.

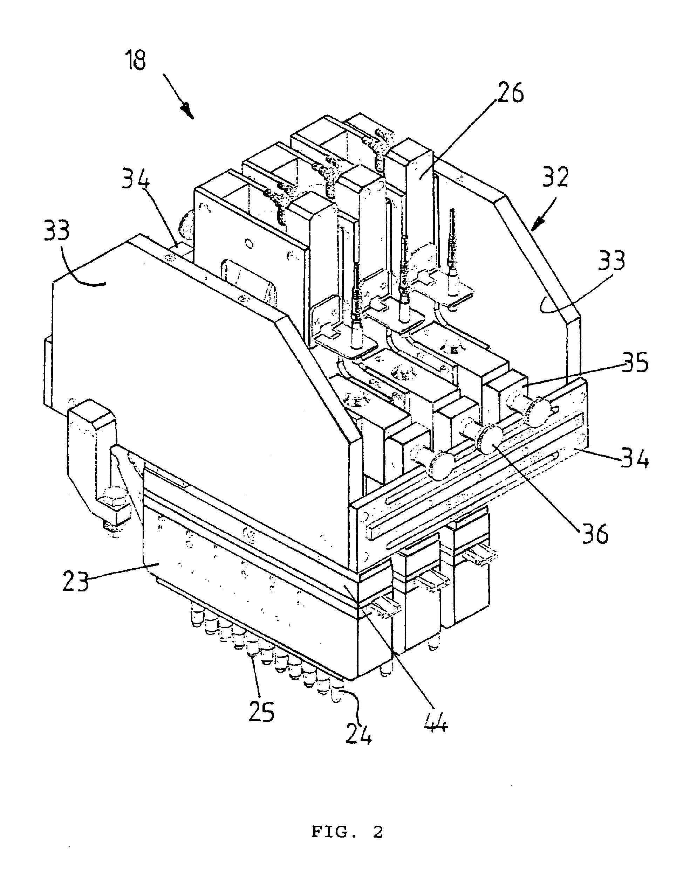

Die Fig. 2 zeigt die Löteinheit 18, in deren Gehäuse 32 drei Lötköpfe 22 hängend angeordnet sind. Das Gehäuse 32 ist aus Querwänden 33 gebildet, die durch streifenförmige Längswandteile 34 verbunden sind, an denen Befestigungsmittel 35 für die Lötköpfe 22 vorgesehen sind. Zur formschlüssigen Befestigung der Lötköpfe 22 besitzen die Längswandteile 34 in das Innere des Gehäuses 32 vorspringende Befestigungsplatten 20, durch die das Befestigungsmittel 35, beispielsweise ein Rastbolzen, geführt ist, mit dessen Hilfe die Zustelleinheit 26 in hängender Anordnung im Innenraum des Gehäuses 32 festliegt.
An den Querwänden 33 des Gehäuses 32 sind die Zustelleinheiten 19 zum vertikalen Absenken und Anheben des Niederhalters 21 in die Arbeitsposition und zurück, d.h. bis zum Transportband 8, befestigt (siehe Fig. 1) festgelegt.

Der in Fig. 3 dargestellte Lötkopf 22 setzt sich aus der Zustelleinheit 26 und dem Lötkopfgehäuse 23 mit darin angeordneten Lötstiften 24 zusammen. Das Lötkopfgehäuse 23 ist in Bezug auf die lagefixierte Anordnung von Verbinder 10 und Solarzelle 9 auf dem Transportband 8 aus der horizontalen Verfahrlage L1 in die Arbeitsposition durch die Zustelleinheit 26 vertikal absenkbar.
Zustelleinheit 26 und Lötkopfgehäuse 23 sind miteinander durch einen gegen eine Feder ver- und entriegelbaren Schnellverschluss 36 verbunden, so dass ein einfaches und schnelles Wechseln des Lötkopfgehäuses 23 gewährleistet ist.

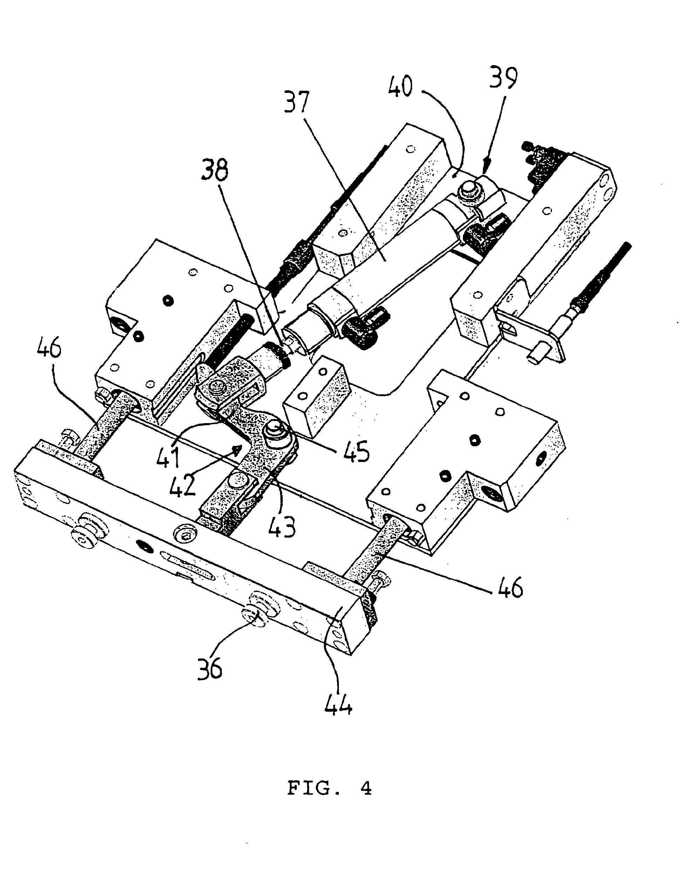

Die Zustelleinheit 26 ist zum Erzeugen einer schnellen vertikalen Zustellbewegung des Lötkopfgehäuses 23 aus der horizontalen Verfahrlage ausgelegt. Die schnelle Zustellbewegung wird durch einen Pneumatikzylinder 37 (siehe Fig. 4) erreicht, der in einer Schräglage innerhalb der Zustelleinheit 26 um sein der Zylinderstange 38 abgewandtes Ende 39 schwenkbar an einer Gehäusewand 40 der Zustelleinheit 22 festgelegt ist. Die Zylinderstange 38 des Pneumatikzylinders 37 ist anderenends mit einem Arm 41 eines Winkelhebels 42 schwenkbar verbunden. Der andere Arm 43 des Winkelhebels 42 ist an einem Träger 44 für das Lötkopfgehäuse 23 schwenkbar befestigt, wobei der Winkelhebel 42 selbst um eine zu den Armen 41 und 43 etwa symmetrisch angeordnete Achse 45 drehbar ist. Die Achse 45 liegt in Flucht des schwenkbaren Endes 39 des Pneumatikzylinders 37. Der Winkelhebel 42 ermöglicht es, die schnelle Zustellbewegung in Bezug auf die Arbeitsposition zu verlangsamen, um ein sanftes Aufsetzen der Lötspitzen 25 auf die Solarzellen 9 sicherzustellen.
Der Träger 44, an dem das Lötkopfgehäuse 23 mit dem Schnellverschluss 36 festliegt, ist in zwei im Gehäuse der Zustelleinheit 22 zueinander parallel angeordneten Führungen 46 vertikal in Richtung Arbeitsposition verschiebbar angeordnet, wodurch das Lötkopfgehäuse 23 mit seinen Lötstiften 24 und Lötspitzen 25 über seine gesamte Länge eine horizontale Lage mit untereinander gleichen Abstand zur Solarzelle 9 beim Absenken einnimmt, so dass ein gleichmäßiges Aufsetzen auf die Solarzelle 9 sichergestellt ist.

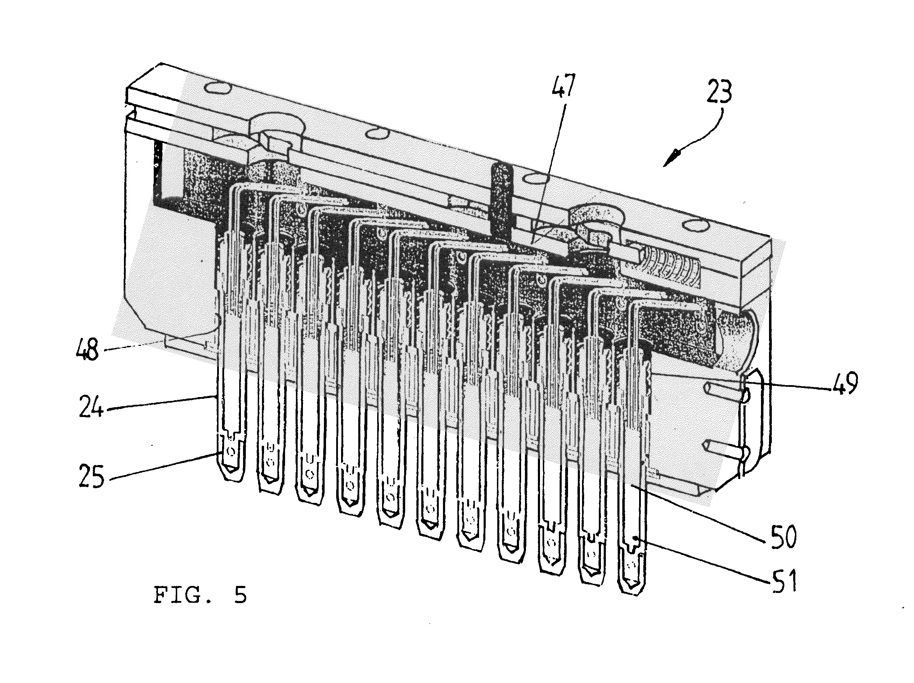

Die Fig. 5 zeigt einen Schnitt des Lötkopfgehäuses 23 mit darin eingesetzten Lötstiften 24.
Das Lötkopfgehäuse 23 ist quaderförmig ausgebildet und an einem Träger 47 befestigt, welcher über den Schnellverschluss 36 mit dem Träger 44 der Zustelleinheit 22 über eine Federkraft ver- und entriegelbar ist.
Im Lötkopfgehäuse 23 sind vertikal angeordnete Führungsbuchsen 48 vorgesehen, in denen die Lötstifte 24 eingesetzt sind. Jeder Lötstift 24 ist in seiner Führungsbuchse 48 gegen ein Ausgleichsystem in Form einer Druckfeder 49 vertikal verschiebbar angeordnet sind, um eine entsprechende Andruckkraft beim Aufsetzen der mit den Lötspitzen 25 versehenen Lötstifte 24 auf Verbinder 10 und Solarzelle 9 zu erzeugen. Die Andruckkraft wird durch die Federkonstante der Druckfeder bestimmt.
Jeder Lötstift 24 besitzt eine eigene Heizpatrone 50 zum Erzeugen der für das Löten erforderlichen Temperatur, die von einem dazugehörigen Temperatursensor 51 überwacht wird.
Die Lötspitze 25 ist als Verschleißteil ausgebildet und auf den Lötstift 24 austauschbar aufgesetzt, so dass die Lötspitze 25 ohne Ausbau des Lötstiftes 24 problemlos gewechselt werden kann.

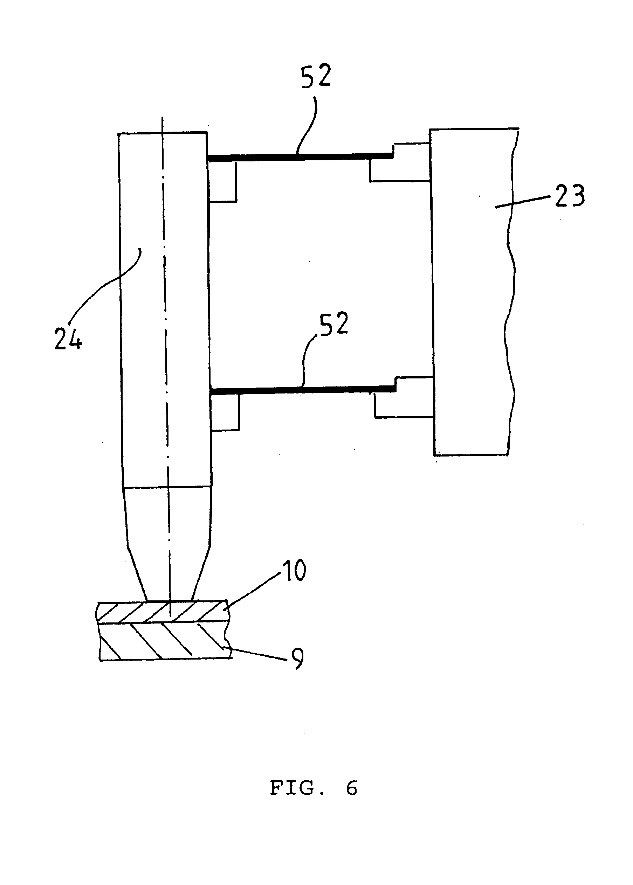

Das Ausgleichsystem zum Aufbringen einer entsprechenden Andruckkraft auf den Verbinder 10 und die Solarzelle 9 kann auch, wie Fig. 6 zeigt, aus mindestens zwei vertikal übereinander angeordneten Blattfedern 52 bestehen, die einerseits am Lötkopfgehäuse 23 und andererseits am Lötstift 24 befestigt sind, wodurch ein Parallelogramm zwischen Lötkopfgehäuse 23, Lötstift 24 und den Blattfedern 52 ausgebildet wird, das sicherstellt, dass sich die Lötspitze 24 bei ihrer Auslenkung parallel zum Lötkopfgehäuse 23 bewegt. Die Blattfedern 52 übernehmen dann sowohl die Funktion der Zustellkraft als auch die Führungsfunktion. Dies ermöglicht, eine Gleitreibung als Störgröße auszuschließen.

An der Zustelleinheit 26 sind die Lötköpfe 22 jeweils einzeln hängend angeordnet. Die Anzahl der Lötköpfe 22 richtet sich dabei nach der Anzahl der Verbinder 10, die mit einer Solarzelle 9 gelötet werden sollen. Mit anderen Worten, sind zur Verbindung der Solarzellen beispielsweise drei parallel zueinander angeordnete Verbinder erforderlich, sind jeweils drei Lötköpfe 22 im entsprechenden Abstand der Verbinder vorzusehen.

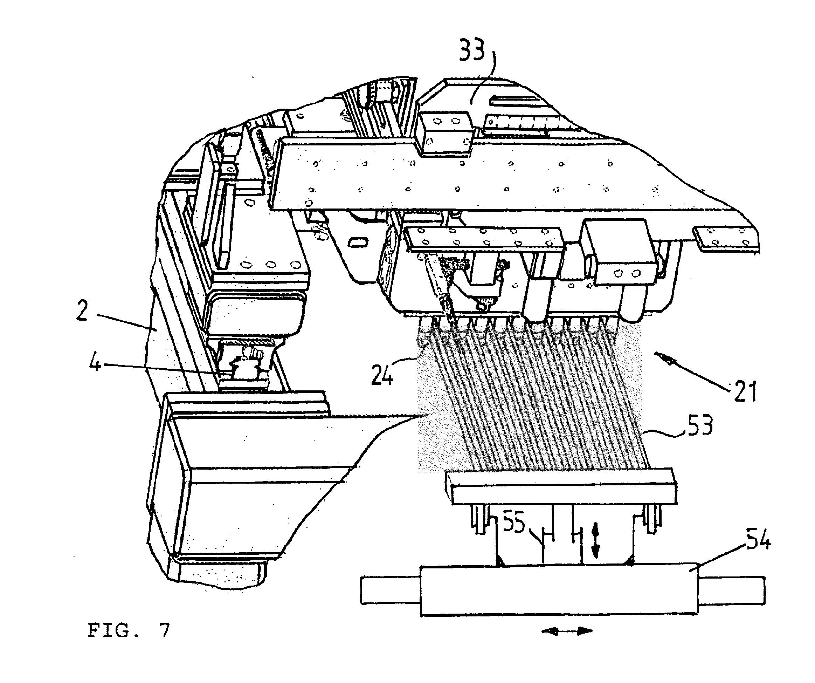

Die Fig. 7 zeigt den Niederhalter 21, der mit seinem separaten Schlitten 54 um maximal einen Zellentakt horizontal synchron mit dem Transportband 8 verfahrbar ist. Eine Zustelleinheit 55, die am Schlitten 54 befestigt ist, trägt die Niederhalterleisten 53, so dass diese in ihre Arbeitsposition zwischen den Lötstiften 24 durch eine vertikale Absenkbewegung bringbar sind oder aus dieser zurück in eine horizontale Verfahrlage zum synchronen Mitfahren zum Transportband 8 gebracht werden können.

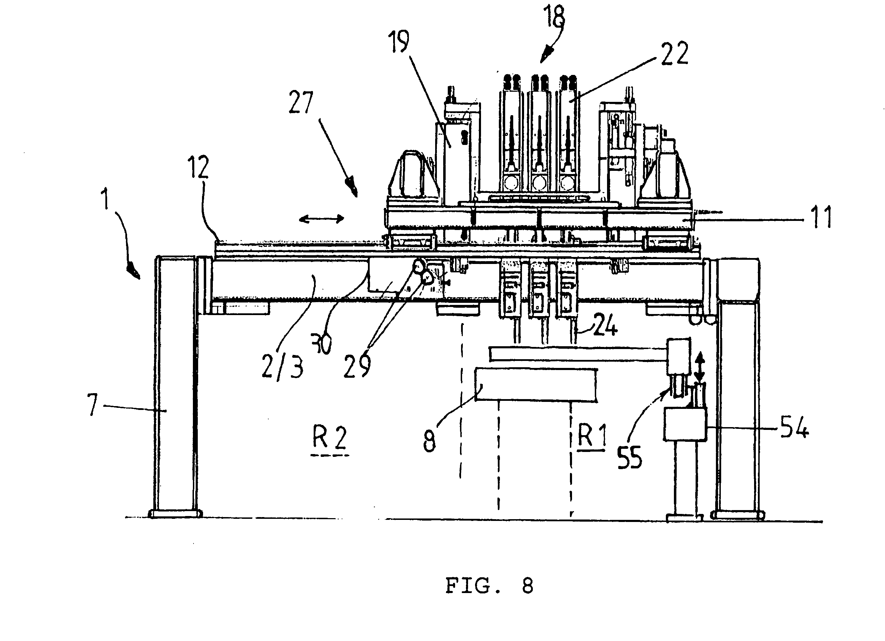

Die Fig. 8 zeigt die Reinigungseinrichtung 27, die im Aufnahmebereich R2 des Grundgestells 1 untergebracht ist. Es wird auf die Abschnitte [0031] und [0032] Bezug genommen, in der die Arbeitsweise und der Aufbau der Reinigungseinrichtung 27 bereits näher erläutert wurden.
Es ist natürlich auch möglich, ohne die Erfindung zu verlassen, die Löteinheit 18 in ihrer horizontalen Verfahrlage L2 zu belassen und die Reinigungseinrichtung 27 durch eine Hubbewegung zuzustellen.

### Bezugszeichenliste

- Grundgestell: 1
- Längsstreben von 1: 2, 3
- Laufschienen: 4
- Querstreben von 1: 5, 6
- Vertikalstützen: 7
- Transportband: 8
- Solarzelle: 9
- Verbinder: 10
- Schlitten: 11
- Linearantrieb für 11: 12
- Elektromotor: 13
- Längsträger von 11: 14, 15
- Querträger von 11: 16, 17
- Löteinheit: 18
- Zustelleinheit für Niederhalter 21: 19
- Befestigungsplatte: 20
- Niederhalter: 21
- Lötkopf: 22
- Lötkopfgehäuse: 23
- Lötstift: 24
- Lötspitze: 25
- Zustelleinheit für Lötkopf 22: 26
- Reinigungseinrichtung: 27
- Elektromotor: 28
- Walzen: 29
- Gehäuse für Walzen 29: 30
- Arbeitsöffnung in 30: 31
- Gehäuse der Löteinheit: 32
- Querwand von 32: 33
- Längswandteil von 32: 34
- Befestigungsmittel: 35
- Schnellverschluß: 36
- Pneumatikzylinder: 37
- Zylinderstange: 38
- Ende von 37: 39
- Gehäusewand von 22: 40
- Arme von Winkelhebel 42: 41, 43
- Träger für 23: 44
- Achse: 45
- Führungen: 46
- Träger: 47
- Führungsbuchse: 48
- Druckfeder: 49
- Heizpatrone: 50
- Temperatursensor: 51
- Blattfedern: 52
- Niederhalterleisten: 53
- Schlitten für 21: 54
- Zustelleinheit für Niederhalterleisten 53: 55
- Verfahrebene: E
- Horizontale Verfahrlage: L1, L2
- Aufnahmebereiche von 1: R1, R2
- Längsrichtung von 8: LR

## Patentansprüche

1. Vorrichtung zum Hochleistungslöten eines Verbinders aus verzinntem Lötband mit einer Solarzelle zur Herstellung von Solarzellenstrings, mit einem von einem Antrieb im Takt angetriebenen Transportband (8) zum Bewegen von Verbinder (10) und Solarzelle (9) in einer zueinander lagefixierten Anordnung zu einer Lötstation, in der während des Lötens eine mechanische Druckkraft auf Verbinder (10) und Solarzelle (9) ausgeübt wird, wobei ein Grundgestell (1) zur Aufnahme mindestens einer auf einem Schlitten (11) am Grundgestell horizontal quer zur Laufrichtung des Transportbandes verfahrbaren Löteinheit (18) mit mindestens einem Lötkopfgehäuse (23), **dadurch gekennzeichnet, dass** die Lötstation umfasst:
a) mindestens eine Zustelleinheit (26) für ein separates vertikales Absenken des Lötkopfgehäuses (23) in eine unterhalb ihrer horizontalen Verfahrlage (L1) gelegenen Arbeitsposition auf der lagefixierten Anordnung von Verbinder (10) und Solarzelle (9) auf dem Transportband (9) oder ein vertikales Anheben aus der Arbeitsposition in die Verfahrlage (L1),
b) Pneumatikzylinder (37) zum Erzeugen einer schnellen Absenkbewegung des Lötkopfgehäuses (23), der in einer Schräglage innerhalb der Zustelleinheit (19, 26) um sein der Zylinderstange (38) abgewandtes Ende (39) schwenkbar angeordnet ist, wobei die Zylinderstange (38) des Pneumatikzylinders mit einem Arm (41) eines Winkelhebels 42), zur Verlangsamung am Ende der Zustellbewegung schwenkbarverbunden ist, dessen anderer Arm (43) schwenkbar an einem Träger (44) für das Lötkopfgehäuse (23) angelenkt ist und der Winkelhebel (42) um eine zu den Armen (41,43) etwa symmetrisch angeordnete Achse (45) drehbar ist;
c) mindestens einen, insbesondere mehrere vom Lötkopfgehäuse (23) gehaltenen, Lötspitzen (25) tragende/n Lötstift/e (24) zum Aufbringen einer definierten Druckkraft beim Aufsetzen der oder des Lötstifte(s) auf den Verbinder (10) und der Solarzelle (9), wobei jeder Lötstift (24) mit einem vertikalen Ausgleichsystem versehen ist, das die Druckkraft beim Löten von Verbinder und Solarzelle durch eine definierte Federkraft aufbringt;
d ein den Lötstiften (24) zugeordneten, horizontal verfahrbaren und vertikal in die bzw. von der Arbeitsposition absenk- oder anhebbaren Niederhalter (21) mit Niederhalteleisten (53) durch eine Zustelleinheit (55) zum Niederhalten der Verbinder (9) auf der Solarzelle (9) beim Löten in der Arbeitsposition oder zum Freigeben der Solarzelle (9) nach dem Löten und Abkühlen zu ihrem taktweisen Weitertransport mit dem Transportband (8);
e eine jeder Löteinheit (18) quer zur Laufrichtung (LR) des Transportbandes (8) zugeordnete Reinigungseinrichtung (27) zum periodischen Reinigen der mit Lötspitzen (25) versehenen Lötstifte (24).

2. Vorrichtung nach Anspruch 1, **dadurch gekennzeichnet, dass** zum horizontalen Verfahren des Schlittens (11) ein elektrischer oder pneumatischer Antrieb (13), vorzugsweise Elektromotor, vorgesehen ist.

3. Vorrichtung nach Anspruch 1, **dadurch gekennzeichnet, dass** das Lötkopfgehäuse (23) mindestens eine vertikal angeordnete Führungsbuchse (48) aufweist, in der der Lötstift (24) linear geführt angeordnet ist.

4. Vorrichtung nach Anspruch 1, **dadurch gekennzeichnet, dass** als Ausgleichsystem für den Lötstift (24) eine in die Führungsbuchse (48) eingesetzte Druckfeder (49) vorgesehen ist.

5. Vorrichtung nach Anspruch 1, **dadurch gekennzeichnet, dass** als Ausgleichsystem mindestens zwei vertikal übereinander angeordnete, den Lötstift (24) haltende Blattfedern (52) vorgesehen sind, die am Lötkopfgehäuse (23) befestigt sind.

6. Vorrichtung nach Anspruch 1, **dadurch gekennzeichnet, dass** der Träger (44) für das Lötkopfgehäuse (23) in zueinander parallel angeordneten Führungen (46) vertikal verschiebbar ist.

7. Vorrichtung nach Anspruch 1, **dadurch gekennzeichnet, dass** ein Schnellverschluß (36) zum mechanischen Verbinden von Zustellstelleinheit (26) und Lötkopfgehäuse (23) vorgesehen ist.

8. Vorrichtung nach Anspruch 1, **dadurch gekennzeichnet, dass** die Zustelleinheiten (19,26) zum Erzeugen der Zustellbewegung mit einem elektrischen Antrieb versehen sind.

9. Vorrichtung nach Anspruch 1, **dadurch gekennzeichnet, dass** die Anzahl der in der Löteinheit (18) einzeln aufgehängten Lötköpfe (22) der Anzahl der an der Solarzelle (9) anzulötenden Verbinder (10) entspricht.

10. Vorrichtung nach Anspruch 1, **dadurch gekennzeichnet, dass** im Lötstift (24) eine mit einem Temperatursensor (51) versehenen Heizpatrone (50) angeordnet ist.

11. Vorrichtung nach Anspruch 1, **dadurch gekennzeichnet, dass** die Lötspitze (25) als austauschbares Verschleißteil ausgebildet ist.

12. Vorrichtung nach Anspruch 1, **dadurch gekennzeichnet, dass** der Niederhalter (21) mindestens eine separat vertikal verfahrbare Zustelleinheit (55) zum Absenken und Heben der Niederhalterleisten (53) aufweist, die am Schlitten (54) befestigt sind.

13. Vorrichtung nach Anspruch 1 und 14, **dadurch gekennzeichnet, dass** der Niederhalter (21) mit dem Schlitten (54) um maximal einen Zellentakt horizontal verfahrbar ist.

14. Vorrichtung nach Anspruch 14, **dadurch gekennzeichnet, dass** die mit der Zustelleinheit (55) verbundenen Niederhalterleisten (53) quer zur Längsrichtung des Transportbandes (8) zwischen den Lötspitzen (25) einfahrbar angeordnet sind.

15. Vorrichtung nach Anspruch 1, **dadurch gekennzeichnet, dass** das Lötkopfgehäuse (23) mittels der Zustelleinheit (26) und einer weiteren Zustelleinheit (19) aus der Arbeitsposition in die horizontale Verfahrlage (L1) bringbar, mit dem Schlitten (11) in die Verfahrlage (L2) über die Reinigungseinrichtung (27) verfahrbar und die Lötstifte (24) und Lötspitzen (25) durch die Zustelleinheit (26) in eine Reinigungsposition bringbar sind.

16. Vorrichtung nach Anspruch 1, **dadurch gekennzeichnet, dass** die Reinigungseinrichtung (27) zwei zueinander gegenläufige, mit einer zur Aufnahme von Reinigungsflüssigkeit geeignete Schwammbeschichtung versehene Walzen (29) aufweist, die mit einem Elektromotor (28) zum Antrieb verbunden sind.

17. Vorrichtung nach Anspruch 1, **dadurch gekennzeichnet, dass** die Reinigungseinrichtung (27) durch eine Zustelleinheit vertikal anhebbar ausgebildet ist.

## Claims

1. Device for high-performance soldering a connector consisting of a tinned strip to a solar cell for producing solar cell strings by means of a feeding belt (8) discontinuously operated by a drive for moving connector (10) and solar cell (9) in fixed in relation to each other positions to a soldering station, in which during soldering is exercised a mechanical compressive force on connector (10) and solar cell (9), wherein a basic mount (1) serves for receiving at least one horizontally transverse to the moving direction of the feeding belt movable at the basic mount on a slide (11) soldering unit (18) with at least one soldering head casing (23), **characterized in that** the soldering station comprises:
a) at least one positioning unit (26) for separately vertically lowering the soldering head casing (23) to a lying beneath its horizontal moving position (L1) working position on the position-fixed arrangement of connector (10) and solar cell (9) on the feeding belt (8) or vertically lifting it from the working position into the moving position (L1),
b) a pneumatic cylinder (37) to create a fast lowering movement of the soldering head casing (23), that in an inclined position inside the positioning unit (19, 26) is arranged swiveling around its end (39) opposite to the cylinder rod (38), wherein the cylinder rod (38) of the pneumatic cylinder is swiveling connected to one lever (41) of a knee lever (42) to decelerate the speed at the end of the feeding movement, the other lever (43) of which is swiveling connected at a carrier (44) for the soldering head casing (23) and the knee lever (42) is rotating around an axle (45) almost symmetrically arranged with regard to the levers (41, 43),
c) at least one, especially several hold by the soldering head casing (23) soldering pin/s (24) with soldering tip/s (25) to impact a defined compressive force when the terminal pin/s is/are set on the connector (10) and the solar cell (9), wherein every soldering pin (24) is provided with an vertical compensation system, which applies the compressive force during soldering by means of a defined spring power,
d) an allocated to the soldering pins (24) by means of a positioning unit (55) horizontally movable and vertically lowerable or liftable blank holder (21) with hold-down bars (53) to hold down the connectors (10) on the solar cell (9) during soldering in the working position or to release the solar cell (9) after soldering and cooling-down for its cyclical onward transport by means of the feeding belt (8),
e) an allocated to each soldering unit (18) transverse to the moving direction (LR) of the feeding belt (8) cleaning unit (27) for periodically cleaning the soldering pins (24) having soldering tips (25).

2. Device according to claim 1, **characterized in that** for the horizontal movement of the slide (11) is provided an electric or pneumatic drive (13), preferably an electric motor.

3. Device according to claim 1, **characterized in that** the soldering head casing (23) has at least one vertically arranged guide bush (48) in which the soldering pin (24) is arranged linearly guided.

4. Device according to claim 1, **characterized in that** as compensation system for the soldering pin (24) is provided an inserted in the guiding bush (48) compression spring (49).

5. Device according to claim 1, **characterized in that** as compensation system are provided at least two vertically above each other arranged, holding the soldering pin (24) leaf springs (52) fastened at the soldering head casing (23).

6. Device according to claim 1, **characterized in that** the bearer (44) of the soldering head casing (23) is vertically movable arranged in two positioned parallel to each other guidings (46).

7. Device according to claim 1, **characterized in that** a quick-snap (36) is provided for the mechanical connection of positioning unit (26) and soldering head casing (23).

8. Device according to claim 1, **characterized in that** the positioning units (19, 26) for creating the positioning movements are provided with an electric drive.

9. Device according to claim 1, **characterized in that** the quantity of soldering heads (22) individually suspended in the soldering unit (18) matches with the quantity of connectors (10) to be soldered to the solar cell (9).

10. Device according to claim 1, **characterized in that** in the soldering pin (24) is provided a heating cartridge (50) having a temperature sensor (51).

11. Device according to claim 1, **characterized in that** the soldering tip (25) is an exchangeable wearing part.

12. Device according to claim 1, **characterized in that** the blank holder (21) has at least one separately vertically movable positioning unit (55) for lowering and lifting the hold-down bars (53), which are connected to the slide (54).

13. Device according to claims 1 and 14, **characterized in that** the blank holder (21) with the slide (54) can be horizontally moved by maximally one cell interval.

14. Device according to claim 14, **characterized in that** the connected with the positioning unit (55) hold-down bars (53) are retractably arranged transverse to the longitudinal direction of the feeding belt (8) between the soldering tips (25).

15. Device according to claim 1, **characterized in that** the soldering head casing (23) by means of the positioning unit (26) and a further positioning unit (19) can be brought from the working position into the horizontal moving position (L1), by means of the slide (11) can be brought into the moving position (L2) over the cleaning unit (27), and that the soldering pins (24) and the soldering tips (25) by means of the positioning unit (26) can be brought into a cleaning position.

16. Device according to claim 1, **characterized in that** the cleaning unit (27) has two rolls (29) moving in opposite to each other directions, provided with a sponge coat which is able to absorb cleansing liquor, connected to an electrical motor (28) serving as drive.

17. Device according to claim 1, **characterized in that** the cleaning unit (27) can be vertically lifted by means of a positioning unit.

## Revendications

1. Dispositif de brasage à haut rendement d'un connecteur en bande de brasage étamée avec une cellule solaire pour la fabrication de chaînes de cellules solaires, comportant une bande transporteuse (8) entraînée en cadence par un entraînement pour le déplacement du connecteur (10) et de la cellule solaire (9) selon un agencement en position fixe l'un par rapport à l'autre jusqu'à une station de brasage, dans laquelle pendant le brasage une force de pression mécanique est exercée sur le connecteur (10) et la cellule solaire (9), un bâti (1) pour la réception d'au moins une unité de brasage (18) déplaçable sur un coulisseau (11) au niveau du bâti horizontalement et transversalement au sens de la marche de la bande transporteuse avec au moins un logement de têtes de brasage (23), **caractérisé en ce que** la station de brasage comprend :
a) au moins une unité de réglage (26) pour un abaissement vertical séparé du logement de têtes de brasage (23) dans une position de travail agencée en dessous de sa position de déplacement horizontale (L1) sur l'agencement en position fixe du connecteur (10) et de la cellule solaire (9) sur la bande transporteuse (9) ou un soulèvement vertical depuis la position de travail vers la position de déplacement (L1),
b) un vérin pneumatique (37) pour la génération d'un mouvement d'abaissement rapide du logement de têtes de brasage (23), qui est disposé de manière pivotante dans une position inclinée à l'intérieur de l'unité de réglage (19, 26) autour de son extrémité (39) opposée à la tige de vérin (38), la tige de vérin (38) du vérin pneumatique étant reliée de manière pivotante avec un bras (41) d'un levier coudé (42) pour un ralentissement à la fin du mouvement de réglage, dont l'autre bras (43) est articulé de manière pivotante sur un support (44) pour le logement de têtes de brasage (23) et le levier coudé (42) étant rotatif autour d'un axe (45) disposé à peu près symétriquement par rapport aux bras (41, 43) ;
c) au moins un plot de brasage (24), en particulier plusieurs, portant des pannes (25) et supportés par le logement de têtes de brasage (23), pour exercer une force de pression définie lors de l'application du ou des plots de brasage sur le connecteur (10) et la cellule solaire (9), chaque plot de brasage (24) étant pourvu d'un système de compensation vertical qui exerce la force de pression lors du brasage du connecteur et de la cellule solaire par le biais d'une force élastique définie ;
d) un serre-flan (21) pouvant être abaissé ou soulevé, déplaçable horizontalement et verticalement dans ou depuis la position de travail et associé aux plots de brasage (24) comportant des baguettes de serre-flan (53) par le biais d'une unité de réglage (55) pour serrer les connecteurs (9) sur la cellule solaire (9) lors du brasage dans la position de travail ou pour libérer la cellule solaire (9) après le brasage et la refroidir en vue de la suite de son transport cadencé avec la bande transporteuse (8) ;
e) une installation de nettoyage (27) associée à chaque unité de brasage (18) transversalement au sens de la marche (LR) de la bande transporteuse (8) pour le nettoyage périodique des plots de brasage (24) pourvus de pannes (25).

2. Dispositif selon la revendication 1, **caractérisé en ce que** pour le déplacement horizontal du coulisseau (11) un entraînement électrique ou pneumatique (11), de préférence un moteur électrique, est prévu.

3. Dispositif selon la revendication 1, **caractérisé en ce que** le logement de têtes de brasage (23) présente au moins une douille de guidage (48) disposée verticalement, dans laquelle le plot de brasage (24) est disposé guidé de manière linéaire.

4. Dispositif selon la revendication 1, **caractérisé en ce qu'**en tant que système de compensation pour le plot de brasage (24) est prévu un ressort (49) introduit dans la douille de guidage (48).

5. Dispositif selon la revendication 1, **caractérisé en ce qu'**en tant que système de compensation au moins deux ressorts à lame (52) disposés verticalement l'un au-dessus de l'autre et maintenant le plot de brasage (24) sont prévus, qui sont fixés au niveau du logement de têtes de brasage (23).

6. Dispositif selon la revendication 1, **caractérisé en ce que** le support (44) pour le logement de têtes de brasage (23) est déplaçable verticalement dans des guides (46) disposés parallèlement les uns aux autres.

7. Dispositif selon la revendication 1, **caractérisé en ce qu'**une fermeture rapide (36) est prévue pour le raccordement mécanique de l'unité de réglage (26) et du logement de têtes de brasage (23).

8. Dispositif selon la revendication 1, **caractérisé en ce que** les unités de réglage (19, 26) sont pourvues d'un entraînement électrique pour la génération du mouvement de réglage.

9. Dispositif selon la revendication 1, **caractérisé en ce que** le nombre des têtes de brasage (22) suspendues individuellement dans l'unité de brasage (18) correspond au nombre des connecteurs (10) à braser sur la cellule solaire (9).

10. Dispositif selon la revendication 1, **caractérisé en ce que** dans le plot de brasage (24) est disposée une cartouche chauffante (50) pourvue d'un capteur de température (51).

11. Dispositif selon la revendication 1, **caractérisé en ce que** la panne (25) est configurée en tant que pièce d'usure remplaçable.

12. Dispositif selon la revendication 1, **caractérisé en ce que** le serre-flan (21) présente au moins une unité de réglage (55) séparément déplaçable verticalement pour l'abaissement et le soulèvement des baguettes de serre-flan (53) qui sont fixées au niveau du coulisseau (54).

13. Dispositif selon la revendication 1, **caractérisé en ce que** le serre-flan (21) peut être déplacé horizontalement avec le coulisseau (54) à une cadence de cellules maximale.

14. Dispositif selon la revendication 1, **caractérisé en ce que** les baguettes de serre-flan (53) reliées à l'unité de réglage (55) sont disposées de manière rétractable transversalement au sens longitudinal de la bande transporteuse (8) entre les pannes (25).

15. Dispositif selon la revendication 1, **caractérisé en ce que** le logement de têtes de brasage (23) est déplaçable de la position de travail à la position de déplacement horizontale (L1) au moyen de l'unité de réglage (26) et d'une autre unité de réglage (19), est déplaçable avec le coulisseau (11) dans la position de déplacement (L2) au-dessus de l'installation de nettoyage (27) et les plots de brasage (24) et les pannes (25) sont déplaçables dans une position de nettoyage par le biais de l'unité de réglage (26).

16. Dispositif selon la revendication 1, **caractérisé en ce que** l'installation de nettoyage (27) présente deux cylindres (29) mutuellement opposés pourvus d'un revêtement spongieux adapté pour l'absorption de liquide de nettoyage, lesquels cylindres sont reliés à un moteur électrique (28) pour effectuer l'entraînement.

17. Dispositif selon la revendication 1, **caractérisé en ce que** l'installation de nettoyage (27) est configurée de manière à pouvoir être soulevée verticalement par le biais d'une unité de réglage.
